# EUROPEAN PATENT SPECIFICATION

(11) **EP 2 889 396 B1**
(45) Date of publication and mention of the grant of the patent: **01.11.2017**
(21) Application number: 14200245.0
(22) Date of filing: 23.12.2014
(51) Int. Cl.: C23C 14/56

(54) **Vacuum coater and method of operating a vacuum coater**
Vakuumbeschichtungsvorrichtung und Verfahren zum Betrieb einer Vakuumbeschichtungsvorrichtung
Machine à enduire sous vide et procédé d'exploitation d'une machine à enduire sous vide

(30) Priority: 24.12.2013 GB 201323013
(43) Date of publication of application: 01.07.2015
(73) Proprietor: Bobst Manchester Limited, Heywood, Lancashire OL10 2TL (GB)
(72) Inventor: Copeland, Nicholas, Stalybridge, Cheshire SK15 2SP (GB); Mitchell, Andrew, Shropham, Norfolk NR17 1DS (GB)
(74) Representative: Leadbetter, Benedict

(56) References cited:
- DE-A1- 2 834 910
- JP-A- H08 325 731
- JP-A- S54 155 983
- US-A- 6 044 792
- US-A1- 2007 134 426

## Description

### Field of the Invention

The invention relates to vacuum coaters for coating a polymeric web, methods of operating a vacuum coater, and metal/metal oxide coated polymeric webs.

### Background to the Invention

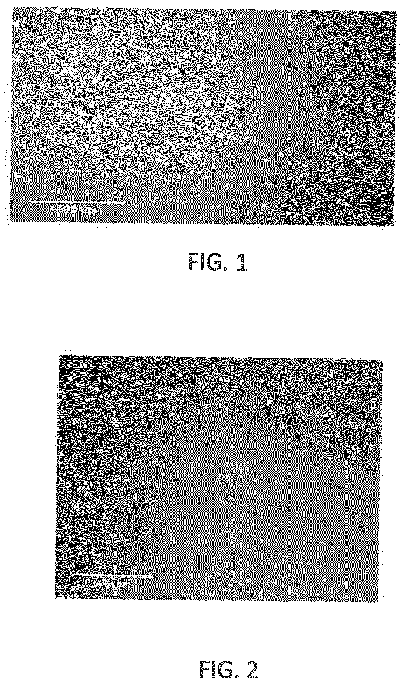

Figure 1 shows an image of a metal coated polymeric web under the microscope. In this particular view there are approximately 75 pin holes greater than 10 microns in diameter for a 3 mm² area. The defect sizes vary generally from 10 to 30 microns in this example. Typical barrier levels in polyethylene terephthalate (PET) currently achieved in the market are defined by oxygen transmission rates (OTR) of approximately 1 cc/m²/day and water vapour transmission rates (WVTR) of approximately 1 to 1.5 g/m²/day for a 2.0 - 2.5 OD on 12 micron commodity grade polyethylene terephthalate (PET). One of the potential objects of embodiments of the invention may be:
- optical improvements (higher opacity per coating thickness);
- more homogeneous conformal coated thin film;
- significant defects reduction (even potentially to the micro size level);
- improved barrier performance; and
- safety improvements (less static on rewind if static is managed correctly in the machine).

When inspecting the vacuum coated film surface under a microscope as shown in Figure 1 a great number of defects are present in the vacuum coated surface. These defects appear in the form of pin-windows where the vacuum coated surface is missing or in extreme cases pinholes where both the vacuum web coated surface and polymer layer are missing. The appearance, shape, size and orientation of the pinholes or windows vary greatly between polymer film types and vacuum coating film suppliers.

There are a number of accepted theories concerning the cause of pin windows in the vacuum coated surface. One theory widely acknowledged is that pin windows are primarily caused by dust or debris being present on the surface of the incoming film to be metallised. As the film passes through the evaporation zone the coating deposits on both the polymer web and on top of the debris. During subsequent handling of the web on rollers through the process, the debris can be moved along with the vacuum coating resulting in pin windows. Occasionally, the debris are believed not only to roll away but to slide away so that under the microscope, the pin windows appear to be a scratch or an elongate window leading away from the unmetallised area.

Another cause of pin windows or pinholes that are larger in size is connected to "spitting" of the metal or evaporant from the resistance heated evaporator boat. The metal or evaporant from the boat can be ejected with sufficient energy to melt a hole through the polymeric web which may have a catastrophic effect on the oxygen barrier. By contrast, when there is less energy in the material from the "spit", a pin window will result where the polymer is still intact. Another cause of pin windows is connected to "pick-off" where the vacuum coating is removed from the web in regions where it has lower adhesion to the polymer web. When the coated surface is in contact with rollers in the machine, coating can transfer from the polymer web onto the roller. The low adhesion of the vacuum coating can be caused by oligomers migrating to the surface of the polymer film, fillers in the polymer film, additives in the polymer film and polymer surface energy.

A contact method to remove debris from the surface of the polymeric film has been developed and is often referred to as the "tacky roll" method. This is where a "tacky" or "sticky" roll contacts the surface of the polymeric film and the debris on the polymeric film sticks to the tacky roll in preference to the film and is therefore transferred off the film. The "tacky" roll can quickly lose its tack and the quantity of debris transferred to it increases and therefore it is common to have a second high tack roll that removes the debris that accumulate on the first "tacky" roll. The second higher tack roll can be changed periodically when it becomes too clogged with debris. This method is claimed to remove debris down to 0.3 microns and has the advantage that it can be used in a vacuum coating system.

The following prior art documents are acknowledged: JP2006152448, US4,393,091, US4,815,415, US4,740,385 and JP2013-124377

After deposition each one of the embodiments of these prior art documents shows a number of rollers directly in contact with the metallised surface of the web. The documents JP08325731 A, JP54155983 A and US2007/0134426 A1 disclose different apparatuses for continuous coating of elongated substrates by evaporation and condensation. However, none of the documents disclose the combination of a deposition region separated from the winding regions, the substrate being supported only on the uncoated side and unwind and rewind regions on the same side of the deposition region.

### Summary of the Invention

In a broad independent aspect, the invention provides a vacuum coater for coating a polymeric web according to claim 1 and a method for operating the coater according to claims 10. The advantage of this solution is best illustrated in the results of figure 2. By providing a number of post-drum rollers solely in contact with the uncoated polymeric surface electrostatic discharge is substantially prevented and a dramatic reduction of the presence of defects is experienced. Preferably, two or more rollers of this kind provide a further reduction of defects. Preferably, three or more rollers of this kind provide a further reduction of defects. Preferably, four or five rollers of this kind provide a further reduction of defects. Preferably, both the unwind and rewind regions are provided on a first side of the vacuum coater and the path between the drum and the rewind reel comprises at least one roller which is located further away from the rewind region than the drum and a plurality of further rollers which are located in closer proximity to the rewind reel than said drum; both the roller located further away from the rewind reel and those in closer proximity to the rewind reel are located within the path defined by the web and contact the uncoated surface of the web throughout the path between the drum and the rewind reel.

In a subsidiary aspect, said number of pre-drum rollers are configured to solely support said web prior to the deposition on the opposite side of the web to the side where metal or metal oxide is to be deposited.

In a subsidiary aspect, at least one of said pre and post-drum rollers incorporates a polymeric coating on the surface of the roller.

In a subsidiary aspect, at least one or more of the post-drum rollers has a mean surface smoothness of 0.012 Ra to 0.20 Ra, preferably 0.012 Ra to 0.025 Ra or a maximum height of 0.05 Rz to 0.1 Rz, preferably 0.05 Rz to 0.8 Rz.

In a subsidiary aspect, the vacuum coater further comprises means for preventing or minimising the discharge of electrostatic charge after deposition; wherein said means are selected from the group comprising:
- at least one of said post-drum rollers being electrically isolated;
- at least one of said post-drum rollers being non-electrically conductive;
- at least one of said post-drum rollers being supported by non-conductive bearings;
- at least one electrically floating roller after the deposition.

In a subsidiary aspect, at least one of said pre-drum rollers is earthed to substantially remove or at least reduce electrostatic charge from said web.

In a subsidiary aspect, the coater further comprises a controllable discharge means selected from one or more of the following:
- a static discharge bar;
- means for generating an ionised gas and for exposing said web to ionised gas after deposition;
- means for injecting an ionised gas in the vicinity of a web to passivate said web;
- a plasma treater prior to deposition;
- a plasma treater after deposition; preferably prior to contact with the first post-drum roller;
- a plasma treater for applying a plasma treatment in the region where the web separates from the evaporator's drum;
- a static discharge means;
- means for controlling the speed of either the web or the rollers;
- means for varying the pressure regime;
- rollers with a configuration which tends to spread the web as the web is drawn over the rollers;
- rollers at least partially of cork, nitrile rubber and steel;
- means for controlling the electromagnetic field generated by said evaporator;

In a subsidiary aspect, said coater further comprises at least one roller with an insulating coating on the surface of the roller, preferably said insulating coating is selected from the group comprising: Cubic Boron Nitride, Aluminium Nitride, and Beryllium oxide.

In a subsidiary aspect, said at least one roller incorporates a ceramic coating on the surface of the roller.

In a subsidiary aspect, a plurality of rollers are provided post-deposition which define a path located on the outmost portion of the succession of rollers.

In a broad independent aspect, the disclosure provides a method of operating a vacuum coater according to any of the preceding aspects comprising the step of solely supporting said web after the deposition on the polymeric surface of the metallised or metal oxide coated web.

In a subsidiary aspect, the method comprises the step of providing a polymeric coating on the surface of one or more roller.

In a subsidiary aspect, the method comprises the step of solely supporting said web prior to the deposition on the opposite side of the web to the side where metal or metal oxide is to be deposited.

In a subsidiary aspect, the method comprises the steps of controlling the discharge of electrostatic charge from the web after the deposition of metal or metal oxide onto the web.

In a subsidiary aspect, the method comprises the steps of preventing the discharge of electrostatic charge from the web after the deposition of metal or metal oxide onto the web.

in a broad independent aspect, the present disclosure provides a method of operating a vacuum coater comprising the steps of handling a polymeric web through the coater in order to reduce the generation of electrostatic charge prior to and during the deposition of metal or metal oxide onto the web and/or to control or prevent the discharge of electrostatic charge from the web after the deposition of metal or metal oxide onto the web.

This method is particularly advantageous in certain embodiments it allows the elimination of micro-defects and pin-windows from forming in a vapour deposited surface. It also reduces or prevents in certain embodiments discharging of charge between the vacuum coated surface and rollers where these are in contact with the vacuum coated surface.

Contrary to conventional thinking whilst the presence of triboelectric charging between a polymeric web and rollers is a known occurrence in vacuum coaters, the skilled man's thinking is conditioned to believe that the pinholes arise primarily due to the presence of debris and that any effort in achieving a reduction in micro defects will be achieved through careful handling of the web to remove the presence of debris. To their surprise, the inventors have discovered that by primarily controlling the electrostatic charges in the vacuum coaters a dramatic reduction in defects can be achieved as illustrated in Figure 2 which shows an image of a polymeric web under the microscope where appropriate electrostatic charge management has been carried out in the process. US4,815,415, US4,740,385 and JP2013-124377 were found carrying out a word search for the terms "metalliser" and "electrostatic" but neither of these tackle the pin window problem in the same manner and with the effectiveness demonstrated in Figure 2. In particular, US4,740,385 and US4,815,415 seek to overcome a problem of adherence of the film to the drum of the evaporator. It concerns difficulties in pulling the web through the coater by employing a plasma treatment to produce very extensive if not complete decay of electrostatic charge as it exits the drum of the evaporator. This provokes even more rapid electrostatic discharge than in conventional coaters where the metallic film traditionally engages a roller in the rewind portion of the coater. Whilst this teaching may achieve the reduction in adhesion between the polymeric surface of the web and the drum it will actually accelerate the presence of pin windows in the metallised film which coats the polymeric web. Similarly, JP2013124377 acts on the polymeric surface of the coated web by mechanically separating the web from the drum upon exit by blowing a gas and then subsequently further treating the polymeric surface with ultraviolet rays from an optical source. These prior art documents may well prevent undue creasing and tearing of the coated web due to uneven adhesion of the polymeric surface to the drum, they do not improve the barrier levels which may be achieved by following the teaching of the present invention.

In a further subsidiary aspect, the method comprises the step of solely supporting the web after the deposition on the polymeric surface of the metallised or metal oxide coated web. This configuration prevents catastrophic electric discharge with the technical effects mentioned in detail in the previous sections.

In a further subsidiary aspect, the method further comprises the step of providing one or more rollers post deposition with a mean surface smoothness of 0.012 Ra to 0.20 Ra or maximum height of 0.05 Rz to 0.8 Rz.

In a further subsidiary aspect, the mean surface smoothness is of 0.012 Ra to 0.025 Ra or the maximum height is of 0.05 Rz to 0.1 Rz.

In a further subsidiary aspect, the method comprises the step of providing at least one roller with an insulating coating on the surface of the roller. This configuration is particularly advantageous when in certain embodiments the roller is located in the rewind portion of the coater which provides a barrier to the otherwise abrupt discharge post-metallisation.

In a subsidiary aspect, the insulating coating comprises material selected from the group comprising - Cubic Boron Nitride, Aluminium Nitride, and Beryllium oxide. These individual materials have particularly advantageous combinations of insulating barrier properties whilst being readily formed to provide a relatively smooth surface to minimise the generation of tribocharges when interacting with the polymeric web. These also offer advantageous cooling properties

In a further subsidiary aspect, at least one roller incorporates a ceramic coating on the surface of the roller. This configuration is particularly advantageous in terms of its potential insulative properties, in reducing cooling and in providing a relatively smooth surface. Preferably, the ceramic coating may have poor thermal conductivity. In further embodiments, the ceramic coating may have improved thermal conductivity (for example Boron Nitride or Aluminium Nitride).

In a further subsidiary aspect, said at least one roller incorporates a polymeric coating on the surface of the roller. This configuration is particularly advantageous in terms of electrical insulation when used in preferred embodiments in the rewind portion of the coater. In preferred embodiments, the polymeric coating may have a relatively smooth surface and may be selected from materials that are more neutral in the triboelectric series.

In a further subsidiary aspect, the method further comprises the step of providing at least one roller prior to the deposition which is earthed to control the polarity of the electrostatic charge on the polymeric web surface. This method may be particularly advantageous in terms of its effects in certain embodiments on nucleation, growth, or densification of different coating types depending on the charge polarity on the surface of the web at the point of coating. In particular, favourable substrate biasing may arise depending on the coating(s) applied.

In a subsidiary aspect, the invention provides a method with a further step of providing at least one roller after the deposition; said at least one roller being isolated in order to at least reduce the discharge of electrostatic charge after the deposition. This reverses conventional thinking that discharge after deposition is to be accelerated. As indicated above the inventors have identified that by controlling the reduction or preventing the discharge in the rewind zone of the coater and in particular immediately after the evaporator a significant reduction in the presence and size of pin windows or holes may be achieved.

In a subsidiary aspect, the roller is non-electrically conductive. This configuration is particularly advantageous in terms of reducing the discharge of electrostatic charge after the deposition. This configuration will also have advantageous effects in terms of reducing other kinds of potential electric discharge.

In a further subsidiary aspect, the method further comprises the step of providing at least one roller after the deposition which is supported by non-conductive bearings. This configuration is also instrumental in minimising the generation of pin windows/holes contrary to the current developed thinking of the skilled person.

In a further subsidiary aspect, the method comprises the step of providing at least one electrically floating roller after the deposition. This configuration is also particularly advantageous in terms of reducing the generation of pin windows/holes in a metallised or metal oxide coated web.

In a subsidiary aspect, the method further comprises the step of providing at least one roller prior to the deposition which is earthed to substantially remove or at least reduce electrostatic charge from the web particularly if the web is conductive. This configuration minimises the production of triboelectric charges in the unwind section of the coater in order to significantly lessen the potential sudden discharge of electrostatic charges after the coating phase of the process.

In a further subsidiary aspect, the method further comprises the step of solely supporting the web prior to the deposition on the opposite side of the web to the side where metal or metal oxide is to be deposited. This minimises triboelectric charging in the unwind section due to the friction between rollers in the unwind section and the polymeric web.

In a further subsidiary aspect, the method further comprises the step of providing a controllable static discharge means after the deposition. Contrary to the prior art where the discharge is controllably accelerated, the controllable static discharge means provides control of the discharge in order to minimise the unwanted generation of pin windows/holes and other defects.

In a further subsidiary aspect, the static discharge means is a static discharge bar. This allows a localised but controllable discharge to be achieved without the uncontrollable nature of the prior art embodiments.

In a further subsidiary aspect, the controllable static discharge means incorporates means for generating an ionised gas; and said method comprises the step of exposing the web to the ionised gas after the deposition. This configuration is particularly advantageous in terms of providing controlled neutralisation of the polymeric web in order to avoid or at least minimise any effects of the electrostatic charge.

In a subsidiary aspect, the ionised gas is injected in the vicinity of the web to passivate the web.

In a further subsidiary aspect, the method further comprises the step of applying a plasma treatment prior to the deposition in order to reduce static in the web. Contrary to prior art plasma treatments this plasma treatment aims at neutralising the charge on the web in order to avoid or at least limit the effects of electrostatic discharge in the formation of pin windows and pin holes further in the process.

In a further subsidiary aspect, the method comprises the step of applying a plasma treatment after the deposition. This configuration is also particularly advantageous in terms of reducing the static in the web in order to minimise the electrostatic discharge which would otherwise take place in the rewind section of the coater.

In a further subsidiary aspect, the method comprises the step of applying a plasma treatment immediately after the deposition prior to any contact with a roller provided in the rewind region of the coater. This configuration is particularly advantageous in terms of passivation of the metallised web prior to any contact with a roller.

In a further subsidiary aspect, the method further comprises the step of providing an evaporator and a drum; and applying a plasma treatment in the region where the web separates from the evaporator's drum.

In a further subsidiary aspect, the plasma treatment is a non-contact plasma passivation treatment. This configuration is particularly advantageous since it avoids the further generation of triboelectric charges whilst providing advantageous passivation treatment.

In a further subsidiary aspect, the plasma treatment is a static discharge plasma treatment. This configuration is particularly advantageous in embodiments where the plasma treatment station itself is not earthed in order to prevent electrostatic discharge through the plasma treater itself.

In a further subsidiary aspect, the method comprises the step of controlling the speed of operation in order to reduce the generation of electrostatic charge.

This configuration further minimises the production of electrostatic charge through the interaction of the components of a coater and therefore also reduces the level of electrostatic discharge.

In a further subsidiary aspect, the method comprises the step of assessing any variation between the speed of the web and the rotation of the rollers, and controlling the speed of either the web or the rollers in order to reduce the generation of electrostatic charge.

In a further subsidiary aspect, the invention provides a method which comprises the step of varying the pressure regime of the coater in order to reduce the generation of electrostatic charge.

In a further subsidiary aspect, the method comprises the step of creating a vacuum in the unwind portion of the coater which is under a pressure of 5x10⁻² mbar. This configuration is particularly advantageous in reducing the likelihood of pin holes in a coated web.

In a further subsidiary aspect, the method comprises the step of operating the coater in at least one zone under a pressure in the region of 10⁻⁴ mbar. This configuration is particularly advantageous in embodiments where plasma discharging onto rollers may arise due to charge levels exceeding breakdown voltage of residual gas and plasma generation between the micro-topography of a roller and the film surface.

In a further subsidiary aspect, the method provides the step of operating the coater in at least one zone prior to the deposition under a pressure in the region of 10⁻² mbar. This configuration may be particularly advantageous in embodiments where a third zone is pumped to this pressure with water vapour traps located in the zone separate from the first zone of the coater to remove moisture from the film prior to entering the evaporation zone.

In a further subsidiary aspect, the method provides the step of controlling the spreading of the web in order to reduce the generation of electrostatic charge.

In a further subsidiary aspect, the method provides the step of selecting a roller surface material suitable for controlling/reducing electrostatic charging. In a preferred embodiment, the selected material is used throughout the metallizer which greatly reduces the amount of tribocharging as the web contacts and separates from the rollers. This may concern any one of the rollers in a coater. It may concern spiral cut, bowed rollers or nips. In a preferred embodiment, materials are selected which are more neutral in the triboelectric series so that they charge materials that come in contact with them to a lesser extent. The appropriate selection of material may also affect the continuous discharging that can occur between a roller and a substrate as it separates from the roller. Most elastomeric materials currently in use are in a region in the triboelectric series where high charging occurs. The continuous discharging onto the elastomeric roller as the film separates may result in ablation and erosion of the elastomeric roller and very fine particles from the rollers may be attracted to the electrostatically charged web which may then be carried into the coating zone where they are coated on top of. Subsequent contact with rollers after coating may result in debris being removed and a different type of more variable "pin window" may form than is caused by electrical discharge onto the roller in contact with the coated surface. In other words, rollers that contact the polymer web throughout the vacuum web coater may be made of materials that are more neutral in the triboelectric series than conventional rollers and have less propensity to release or gain electrons to other materials in contact after separation.

In a further subsidiary aspect, the method provides the step of selecting a material from the group comprising: cork, nitrile rubber and steel.

In a further subsidiary aspect, the method provides the step of matching the speed of one or more rollers with the speed of the web.

In a preferred embodiment, specific rollers incorporate the materials with the properties mentioned above. In particular, spreader rollers, bowed spreader rollers and nip rollers incorporate these advantageous materials. Furthermore, idler rollers, load cell rollers, and draw rollers may also incorporate these advantageous materials.

In a further subsidiary aspect, the method comprises the step of providing an evaporator which produces an electromagnetic field; and controlling the effect of one or more generated electromagnetic fields to which said web is exposed in order to reduce the current induced in the coating. This configuration is particularly advantageous in terms of dealing with both electro-static discharge and any other electric discharge which may arise from current induced by the electromagnetic field produced by the evaporator.

In an embodiment of this aspect, the management and arrangement of an evaporator power source may be configured to take advantage of destructive electromagnetic wave interference to produce smaller or neutralised magnetic fields. In a preferred embodiment, means will be provided to ensure constructive interference does not occur to create larger electromagnetic waves which would increase induced charge effects.

In a further independent aspect, the disclosure provides a method of operating a vacuum coater comprising the steps of handling a polymeric web or the like through the coater in order to reduce the induction of current in the metallised or metal oxide coated web during the deposition of metal or metal oxide onto the web and/or to control or prevent the electric discharge from the coated web after the deposition of metal or metal oxide onto the web. This method also reverses the conventional thinking of associating the occurrence of pin holes and windows with debris and identifies an effect method of avoiding the formation of pin holes and windows by appropriately handling electric charges in the metallised web.

Various embodiments are envisaged in which the electric discharge may be one of the following: brush discharge, dielectric barrier discharge, corona discharge, electric glow discharge, electric arc, electrostatic discharge, electrostatic discharge, electric discharge in gases, leader (spark), partial discharge, streamer discharge, vacuum arc, and so called Townsend discharge.

Various embodiments are envisaged where polymeric webs are coated with aluminium, AlOx, or SiOx, the webs being of for example: PET, BOPP, CPP, OPA, PLA, LDPE, LLDPE, MDPE, HDPE, PEN, PVC, Cellophane, Cellulose acetate, polycarbonate.

In a subsidiary aspect, the method further comprises the step of providing a plurality of evaporators. This configuration reduces the generation of electromagnetic fields per evaporator and therefore reduces the generation of induced current and the risk of catastrophic discharge from the metallised web.

In a preferred embodiment, a 2 drum configuration may be employed with standard or increased drum distance in order to reduce the impact of induction from the electromagnetic field on the conductive layer. In a preferred embodiment, a standard drum configuration at reduced evaporator current may be provided. Alternatively, a 2 drum configuration may be provided with increased drum distance at a normal evaporator current.

In a further subsidiary aspect, the method further comprises the step of increasing the distance between the drum and the evaporator in order to reduce the induction of current in the coated web. This configuration is also particularly advantageous in reducing the potential effects of electric discharge.

In a further subsidiary aspect, the method further comprises the step of off-setting an evaporator relative to a coating drum in order to reduce the induction of current in the coated web. In a preferred embodiment, an offset source may be provided for a single and a double drum arrangement. This configuration is also particularly advantageous in reducing the potential effects of electric discharge.

In a further subsidiary aspect, the method provides one or more rollers post deposition with an increased smoothness level in order to reduce the discharge of induced currents between a roller and a metallised or metal oxide coated web. This can provide a smooth transmission of current from the metallised web to a roller without or with fewer catastrophic electric discharge events.

In a further subsidiary aspect, the method provides one or more rollers post deposition with a mean surface smoothness of 0.012 Ra to 0.20 Ra or maximum height of 0.05 Rz to 0.8 Rz.

In a further subsidiary aspect, the mean surface smoothness is of 0.012 Ra to 0.025 Ra or the maximum height is of 0.05 Rz to 0.1 Rz.

In a further independent aspect, the disclosure provides a method of operating a vacuum coater comprising the step of handling a polymeric web or the like through the coater by providing a conductive roller after the deposition with relief sufficiently smooth to reduce and/or prevent electronic discharge or achieve smooth contact between the coated film and a conductive roller. In a preferred embodiment, this roller is grounded whereby the ultra-smooth contact surface of the roller prevents or at least significantly reduces arc discharge and/or plasma generation.

In a subsidiary aspect, the method provides one or more rollers post deposition with a mean surface smoothness of 0.012 Ra to 0.20 Ra or maximum height of 0.05 Rz to 0.8 Rz. In a subsidiary aspect, the mean surface smoothness is of 0.012 Ra to 0.025 Ra or the maximum height is of 0.05 Rz to 0.1 Rz.

In a further broad independent aspect, the disclosure provides a metal or metal oxide coated polymeric web obtained by a method according to any of the preceding aspects.

In a further aspect, the web is of polyester and has an oxygen transmission rate (OTR) of 0.09 to 0.5 cc/m²/day and a water vapour transmission rate (WVTR) of 0.1 to 0.5 g/m²/day.

In a further broad independent aspect, the disclosure provides a vacuum coater for coating a web with metal or metal oxide comprising an unwind, a deposition and a rewind portion; wherein said coater comprises at least one roller in the unwind portion which is earthed to substantially remove or at least reduce electrostatic charge from the polymeric web. This is particularly advantageous when the web is metallic and substantially electrostatic charge may accumulate in the unwind portion of the coater.

In a further broad independent aspect, the disclosure provides a vacuum coater for coating a polymeric web with metal or metal oxide comprising an unwind, a deposition and a rewind portion; wherein said coater comprises at least one roller with an insulating coating on the surface of the roller.

In a subsidiary aspect, the insulating coating comprises material selected from the group comprising: Cubic Boron Nitride, Aluminium Nitride, and Beryllium oxide. These individual materials are particularly advantageous due their combined properties of insulating barrier properties and being readily formed to provide a relatively smooth surface to minimise the generation of plasma arc discharge within the micro-relief of the roller when interacting with the surface of the vacuum coated polymer.

In a further subsidiary aspect, at least one roller incorporates a ceramic coating on the surface of the roller.

In a further subsidiary aspect, at least one roller incorporates a polymeric coating on the surface of the roller. In certain embodiments, this configuration provides an advantageous potential avoidance of electric discharge in the rewind portion of the coater.

In a further broad independent aspect, the disclosure provides a vacuum coater for coating a polymeric web with metal or metal oxide comprising an unwind, a deposition and a rewind portion; wherein said coater further comprises at least one roller after the deposition portion; said at least one roller being electrically isolated in order to at least reduce the discharge of electrostatic charge after the deposition.

In a further subsidiary aspect, the roller is non-electrically conductive.

In a further subsidiary aspect, the vacuum coater incorporates at least one roller which is supported by non-conductive bearings.

In a further subsidiary aspect, the roller is an electrically floating roller located after the deposition portion.

In a further broad independent aspect, the disclosure provides a vacuum coater for coating a polymeric web with metal or metal oxide comprising an unwind, a deposition and a rewind portion; wherein said coater supports said web after the deposition portion solely on the polymeric surface of the metallised web. This configuration is particularly advantageous in minimising or avoiding altogether electric discharges from the metallised web.

In a further broad independent aspect, the disclosure provides a vacuum coater for coating a polymeric web with metal or metal oxide comprising an unwind, a deposition and a rewind portion; wherein said coater supports said web prior to the deposition solely on the opposite side of the web to the side where metal or metal oxide is to be deposited.

In a further broad independent aspect, the disclosure provides a vacuum coater for coating a polymeric web with metal or metal oxide comprising an unwind, a deposition and a rewind portion; wherein the coater further comprises a static discharge means after the deposition portion.

In a further subsidiary aspect, the static discharge means is a static discharge bar.

In a further subsidiary aspect, the static discharge means incorporates means for generating an ionised gas.

In a further subsidiary aspect, the vacuum coater comprises an injector for injecting ionised gas in the vicinity of the web to passivate the web.

In a further broad independent aspect, the disclosure provides a vacuum coater for coating a polymeric web with metal or metal oxide comprising an unwind, a deposition and a rewind portion; wherein said coater further comprises a plasma source for applying a plasma treatment prior to the deposition in order to reduce static in the web.

In a further broad independent aspect, the disclosure provides a vacuum coater for coating a polymeric web with metal or metal oxide comprising an unwind, a deposition and a rewind portion; wherein said coater further comprising a plasma source immediately after the deposition portion prior to any contact with a roller provided in the rewind region of the coater.

In a further independent aspect, the disclosure provides a vacuum coater for coating a polymeric web with metal or metal oxide comprising an unwind, a deposition and a rewind portion; the coater further comprising a controller for controlling the speed of operation in order to reduce the generation of electrostatic charge.

In a further broad independent aspect, the disclosure provides a vacuum coater for coating a polymeric web with metal or metal oxide comprising an unwind, a deposition and a rewind portion; the coater further comprising means for assessing a variation between the speed of the web and the rotation of the rollers, and a controller for controlling the speed of either the web or the rollers in order to reduce the generation of electrostatic charge.

In a further broad independent aspect, the disclosure provides a vacuum coater for coating a polymeric web with metal or metal oxide comprising an unwind, a deposition and a rewind portion; the coater further comprising means for regulating the pressure regime of the coater in order to reduce the generation of electrostatic charge.

In a further subsidiary aspect, the disclosure provides a vacuum coater for coating a polymeric web with metal or metal oxide comprising an unwind, a deposition and a rewind portion; the coater further comprising an unwind portion which is configured to operate under a pressure of less than 5x10⁻² mbar.

In a further broad independent aspect, the disclosure provides a vacuum coater for coating a polymeric web comprising an unwind, a deposition and a rewind portion; and a rewind portion; the coater further comprising at least one zone which is configured to operate under a pressure in the region of 10⁻⁴ mbar.

In a further broad independent aspect, the disclosure provides a vacuum coater for coating a polymeric web with metal or metal oxide comprising an unwind, a deposition and a rewind portion; the coater further comprising an evaporator which produces an electromagnetic field; and a controller for controlling the effect of generated electromagnetic fields to which said web is exposed in order to reduce the current induced by said electromagnetic field in the conductive coating.

In a further broad independent aspect, the disclosure provides a vacuum coater for coating a polymeric web comprising an unwind, a deposition and a rewind portion; the coater further comprising a controller for controlling the spreading of the web in order to reduce the generation of electrostatic charge.

### Brief Description of the Figures

Figure 1 shows a photograph of a microscopic view of a coated polymeric web of the prior art.
Figure 2 shows a photograph of a microscopic view of the surface of a coated polymeric web obtained in accordance with the invention.
Figure 3 shows a vacuum coater in cross-sectional view in accordance with an embodiment of the invention.
Figure 4 shows an embodiment in cross-sectional simplified view with a single drum and a single source with a contact-free web path post-drum.
Figure 5 shows a simplified cross-sectional view of a coater with a single drum and a single source with a contact-free web both before and after the drum.
Figure 6 shows a simplified cross-sectional view of a coater with a single drum and a single source with an electrically isolated roller after the drum.
Figure 7 shows a simplified cross-sectional view of a coater with a free span single source with a contact free web path post-drum.
Figure 8 shows a simplified cross-sectional view of a free span single source coater where the web is contact free both pre and post-drum.
Figure 9 shows a free span single source coater in a simplified cross-sectional view where a roller is electrically isolated post-drum.
Figure 10 shows a coater with two drums in simplified cross-sectional view where a contact free web is provided after the second drum.
Figure 11 shows a simplified cross-sectional view of a coater with two drums where none of the rollers contacts the metallic surface of the web.
Figure 12 shows a coater in simplified cross-sectional view with two drums and an electrically floating insulated roller provided post-drums.
Figure 13 shows a simplified cross-sectional view of a coater with dual free span sources where the rollers engage the web solely on the non-metallised surface of the coated web.
Figure 14 shows a simplified cross-sectional view of a coater with dual free span sources where the rollers engage the web solely on the non-metallised surface of the coated web.
Figure 15 shows a simplified cross-sectional view of a coater with two drums (one source per drum) where the rollers post-drum only contact the polymeric surface of the web.
Figure 16 shows a simplified cross-sectional view of a coater with two drums, each with their own source and a contact-free web path pre and post-drum.
Figure 17 shows a two drum configuration in simplified cross-sectional view with one source per drum and with electrically floating rollers post-deposition.
Figure 18 shows a simplified cross-sectional view of a coater with four drums with a source per two drums and with rollers that are electrically isolated post-drum.
Figure 19 shows a simplified cross-sectional view of a coater suitable for double-sided coating with both a contact-free arrangement after the first coating station and an insulated set of rollers after the second coating station.
Figure 20 shows a simplified cross-sectional view of a coater suitable for double-sided coating and a contact-free web path pre and post-drums.
Figure 21 shows a simplified cross-sectional view of a coater for double-sided coating with a provision for electrically insulated rollers post-deposition.
Figure 22 shows a simplified cross-sectional view of a coater with plasma passivation/static neutralisation prior to the rewind roll (either in a one-sided deposition process or a two-sided deposition process).
Figure 23 shows a simplified cross-sectional view of a coater with a plasma passivation/static neutralisation station after a floating contact roller. This embodiment may be suitable for one or two-sided deposition.
Figure 24 shows a simplified cross-sectional view of a coater with two sources to reduce electromagnetic induction of currents in the metallised web.
Figure 25 shows a simplified cross-sectional view of a coater where plasma passivation/static neutralisation takes place after the floating or electrically grounded process drum.
Figure 26 shows a simplified cross-sectional view of a coater where the evaporator has been offset.
Figure 27 shows a simplified cross-sectional view of a coater where the distance between the source and the drum has been increased relative to conventional evaporators.
Figures 28a and 28b show electromagnetic waves with either constructive interference in the case of Figure 28a or destructive interference in the case of Figure 28b.

### Detailed Description of the Figures

Figures 1 and 2 have already been described in the Background section and in the Summary of the Invention section.

Whilst the following figures show embodiments of the disclosure any appropriate deposition technique may be employed including for example: PVD resistive "boat style", CVD, PVD magnetron, ALD, Crucible (EB, Induction Heating) etc.

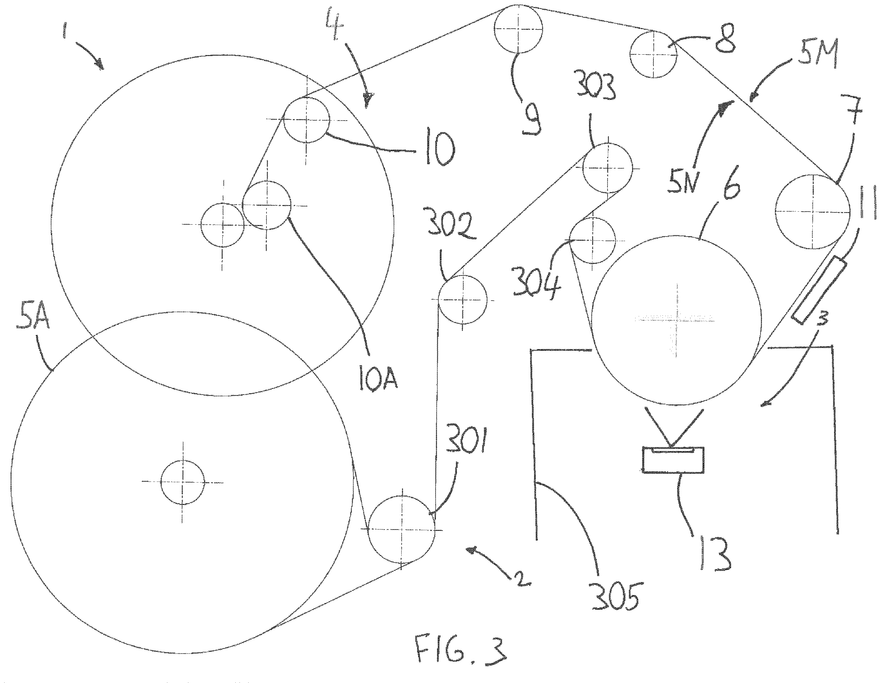

Figure 3 shows a coater generally referenced 1 with an unwind portion 2, an evaporator portion 3 and a rewind portion 4. Most of the components shown may be standard and therefore no detailed description will be provided for these components. A reel of polymeric web 5 is provided in the unwind portion of the coater. A succession of rollers is provided between the reel 5 and the drum 6. Roller 301 is provided as the uncoated web exits the unwind reel. Roller 302 is provided in order to direct the path of the web upwards. Roller 303 is provided in order to direct the path of the web downwards in the direction of the drum. Figure 304 is provided adjacent to the entry to the drum and engages only the surface of the web opposite to the surface which is destined for coating. The metallised web is in the embodiment of Figure 3 supported by a succession of rollers 7, 8, 9, 10 and 10A solely on the non-metallic side 5N of the web, i.e. with the polymeric surface solely in direct contact with the polymeric surface. This non-contact web path at least post deposition is particularly advantageous in terms of preventing an uncontrolled static discharge. Optionally, a plasma treatment station 11 is provided to act on the metallic surface in order to neutralise the charge or achieve controlled static discharge. In other words, the plasma treater may be provided post-evaporator drum to achieve passivation. Walls such as wall 305 serves to segregate the evaporator region with evaporator boat 13 from both the unwind region and the rewind region. An appropriate enclosure is envisaged for the coater which is not shown for simplicity. In the following embodiments appropriate segregation of the evaporator region and the other regions of the coater may be envisaged even if such means are not incorporated in the figures. The following deposition techniques are included for each one of the embodiments and may include: PVD resistive "boat style", CVD, PVD magnetron, ALD, crucible (EB, Induction heating).

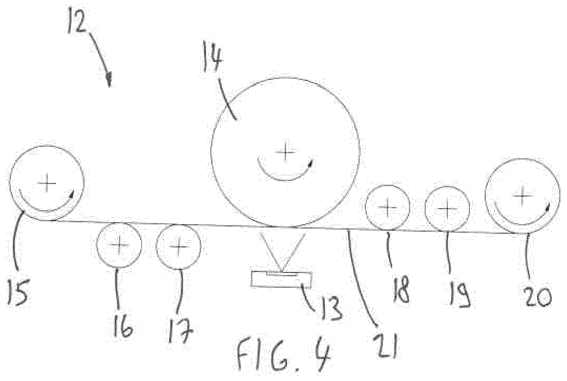

Figure 4 shows a coater 12 with an unwind reel 15, two pre-drum rollers 16 and 17, an evaporator boat 13, a drum 14, two post-drum rollers 18 and 19 and a rewind reel 20. Post-drum rollers 18 and 19 solely enter into contact with the non-metallic side of the coated web 21. These also serve to sufficiently and appropriately space the evaporator region from the rewind region.

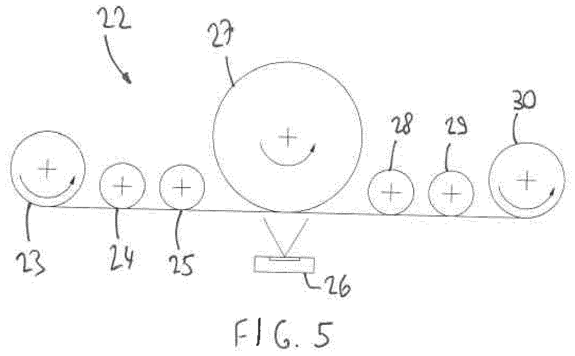

Figure 5 shows a coater generally referenced 22 with an unwind reel 23, two pre-drum rollers 24 and 25, an evaporator boat 26 and a drum 27, two post-drum rollers 28 and 29, and a rewind reel 30 in this configuration. None of the rollers engages the pre-metallisation surface of the web and the coated surface of the web.

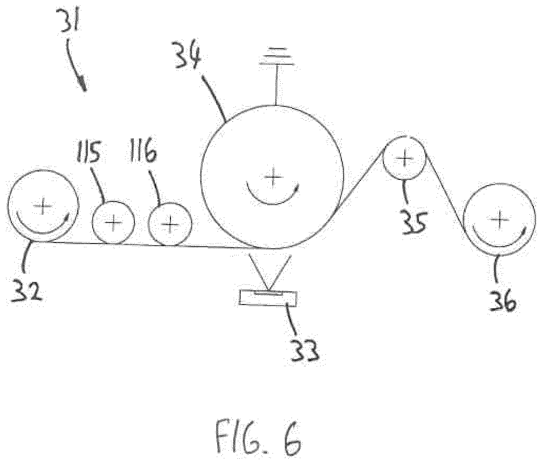

Figure 6 shows a coater 31 with an unwind reel 32, an evaporator boat 33, a drum 34, an electrically floating or insulated roller 35 and a rewind reel 36. Drum 34 may optionally be earthed whilst roller 35 is not grounded. Two pre-deposition rollers 115 and 116 are provided and engage solely the surface of the film opposite to the surface which is coated by evaporator 33.

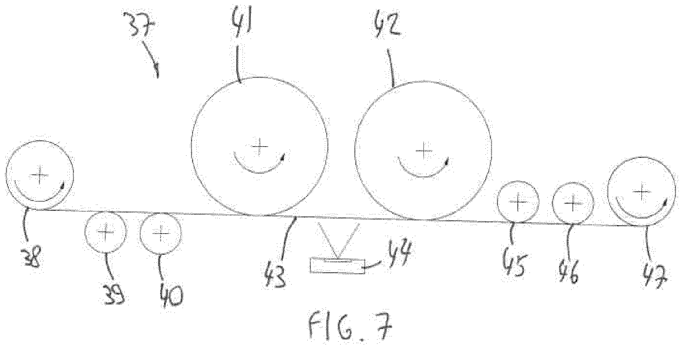

Figure 7 shows a coater 37 with an unwind reel 38, two pre-drum rollers 39 and 40, a pair of drums 41 and 42 presenting a web 43 to an evaporator boat 44, a pair of post-drum rollers 45 and 46, and a re-wind reel 47 in this configuration. The post-drum rollers 45 and 46 solely engage the polymeric surface of the web 43 so as to avoid contact with the newly coated surface of the polymeric web.

In a practical embodiment of figure 7, the unwind region with unwind reel 38 may be located on the same side of the coater as the rewind region 47. The arrangement of rollers may be employed to support and guide the web to and from the pair of evaporator drums. Furthermore, the evaporator region may be segregated from the unwind and rewind regions with appropriate partitions or walls.

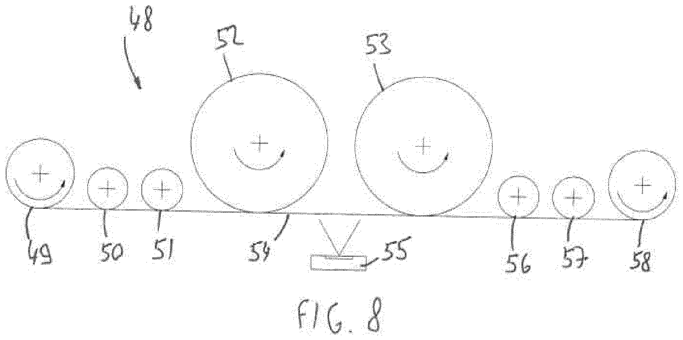

Figure 8 shows a further coater generally referenced 48 with an unwind reel 49, a pair of pre-drum rollers 50 and 51, two drums 52 and 53 presenting a web 54 to an evaporator boat 55, two post-drum rollers 56 and 57 and a rewind reel 58. None of the rollers 50, 51, 56 and 57 engages the surface of the polymeric film which will be and is coated.

In a practical embodiment of figure 8, the unwind region with unwind reel 49 may be located on the same side of the coater as the rewind region 58. The arrangement of rollers may be employed to support and guide the web to and from the pair of evaporator drums. Furthermore, the evaporator region may be segregated from the unwind and rewind regions with appropriate partitions or walls.

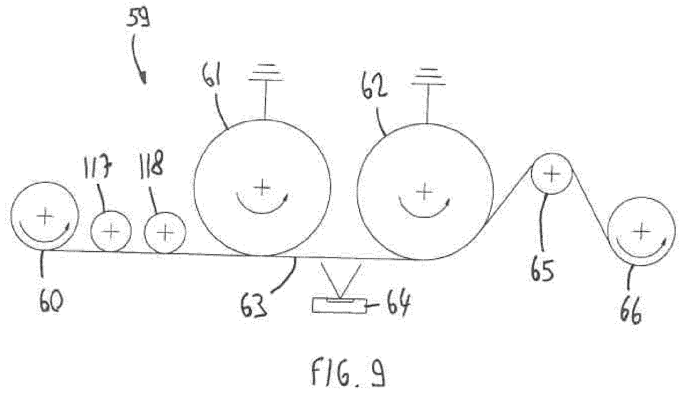

Figure 9 shows a coater 59 with an unwind reel 60, a pair of drums 61 and 62 presenting a web 63 for coating by an evaporator boat 64, an electrically floating or insulated roller 65 located post-drum and a rewind reel 66. Two pre-deposition rollers 117 and 118 are provided and engage solely the surface of the film opposite to the surface which is coated by evaporator 33.

In a practical embodiment of figure 9, the unwind region with unwind reel 60 may be located on the same side of the coater as the rewind region 66. The arrangement of rollers may be employed to support and guide the web to and from the pair of evaporator drums. Furthermore, the evaporator region may be segregated from the unwind and rewind regions with appropriate partitions or walls.

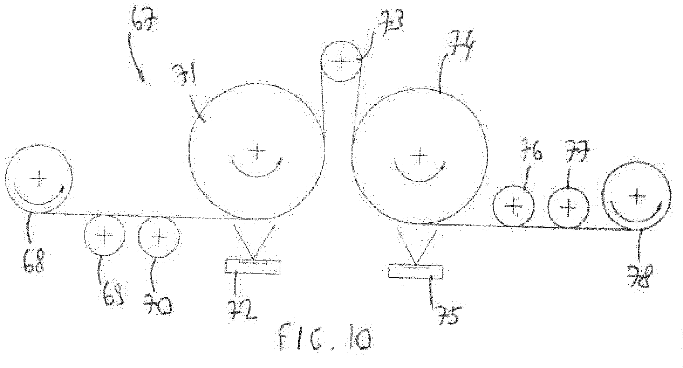

Figure 10 shows a coater 67 with an unwind reel 68, a pair of rollers 69 and 70, a drum 71 operating in conjunction with an evaporator boat 72, an intermediate roller 73, a second drum 74 operating in conjunction with an evaporator boat 75, a pair of rollers 76 and 77 which solely engage the non-coated surface of the web, and a rewind reel 78.

In a practical embodiment of figure 10, the unwind region with unwind reel 68 may be located on the same side of the coater as the rewind region 78. The arrangement of rollers may be employed to support and guide the web to and from the pair of evaporator drums. Furthermore, the evaporator region may be segregated from the unwind and rewind regions with appropriate partitions or walls.

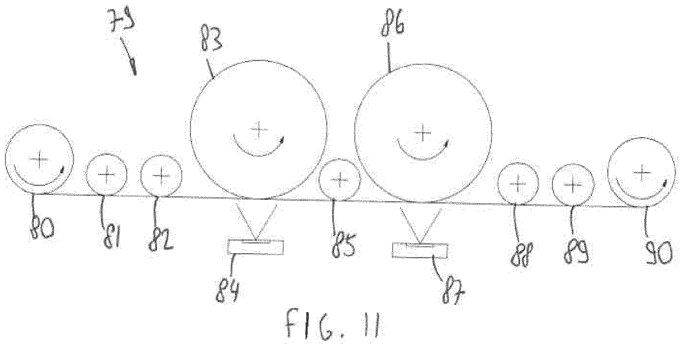

Figure 11 shows a coater 79 with an unwind reel 80, a pair of rollers 81 and 82, a first drum 83 operating in conjunction with an evaporator boat 84, an intermediate roller 85, a second drum 86 operating in conjunction with an evaporator boat 87, and a pair of rollers 88 and 89, and a rewind reel 90. None of the rollers engages the side of the web which is destined or is covered by a metallic coating. In particular, the intermediary roller 85 solely contacts the polymeric side of the web.

In a practical embodiment of figure 11, the unwind region with unwind reel 80 may be located on the same side of the coater as the rewind region 90. The arrangement of rollers may be employed to support and guide the web to and from the pair of evaporator drums. Furthermore, the evaporator region may be segregated from the unwind and rewind regions with appropriate partitions or walls. Whilst the embodiment shows pairs of rollers a greater number of rollers is envisaged with the same properties in order to extend the achievable paths and further increase the advantages already achieved with pairs of rollers of this kind.

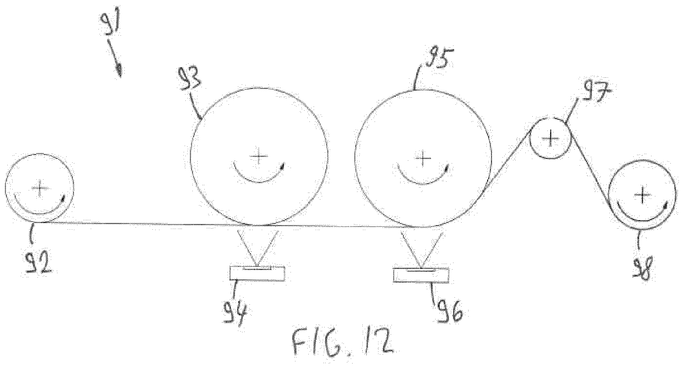

Figure 12 shows a coater 91 with an unwind reel 92, a first drum 93 operating in conjunction with an evaporator boat 94, a second drum 95 operating in conjunction with a second evaporator boat 96, an electrically floating or insulated roller 97, and a rewind roller 98. The roller 97 which enters into contact with the metallic surface of the web is either insulated, designed to electrically float or is not grounded in order to substantially prevent the discharge from the metallised surface.

In a practical embodiment of figure 12, the unwind region with unwind reel 92 may be located on the same side of the coater as the rewind region 98. The arrangement of rollers may be employed to support and guide the web to and from the pair of evaporator drums. Furthermore, the evaporator region may be segregated from the unwind and rewind regions with appropriate partitions or walls.

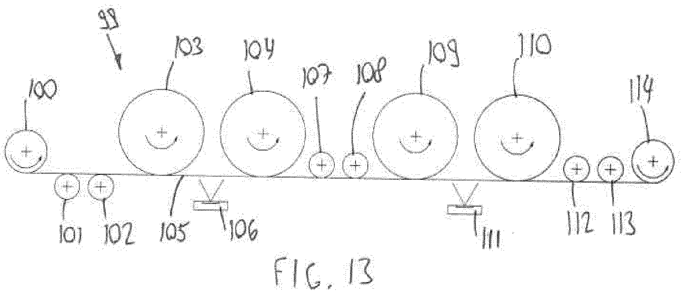

Figure 13 shows a coater 99 with an unwind reel 100, unwind rollers 101 and 102, a pair of drums 103 and 104 presenting a web 105 to a first evaporator boat 106, a pair of intermediary rollers 107 and 108, a pair of drums 109 and 110 presenting the coated web 105 to a second evaporator boat 111, a pair of rollers 112 and 113, and a rewind reel 114. In this configuration none of the rollers 107, 108, 112 and 113 enters into contact with a metallised surface of the web in order to prevent unwanted discharge.
In a practical embodiment of figure 13, the unwind region with unwind reel 100 may be located on the same side of the coater as the rewind region 114. The arrangement of rollers may be employed to support and guide the web to and from the pairs of evaporator drums. Furthermore, the evaporator region may be segregated from the unwind and rewind regions with appropriate partitions or walls. Whilst the embodiment shows pairs of rollers a greater number of rollers is envisaged with the same properties in order to extend the achievable paths and further increase the advantages already achieved with pairs of rollers of this kind.

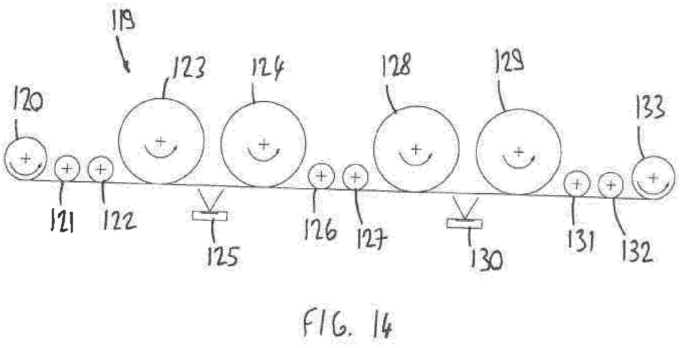

Figure 14 shows a coater generally referenced 119 with an unwind reel 120, two pre-drum rollers 121 and 122, a first pair of drums 123 and 124 operating in conjunction with an evaporator 125 for deposition on the free span of the web between drums 123 and 124, two intermediary rollers 126 and 127, a second pair of drums 128 and 129 located opposite an evaporator 130 for vapour deposition onto the free-span of web, two post-drum rollers 131 and 132, and a rewind reel 133. In this configuration none of the rollers enters into contact with the metallised surface of the web. Furthermore, the evaporators are located between the drums of a pair of drums. Consequently, electric discharge is prevented. Furthermore, the electromagnetic effect of the evaporators is also reduced due to the relative position of the evaporator and its corresponding drums. In a practical embodiment of figure 14, the unwind region with unwind reel 120 may be located on the same side of the coater as the rewind region 133. The arrangement of rollers may be employed to support and guide the web to and from the pairs of evaporator drums. Furthermore, the evaporator region or regions may be segregated from the unwind and rewind regions with appropriate partitions or walls. Whilst the embodiment shows pairs of rollers a greater number of rollers is envisaged with the same properties in order to extend the achievable paths and further increase the advantages already achieved with pairs of rollers of this kind.

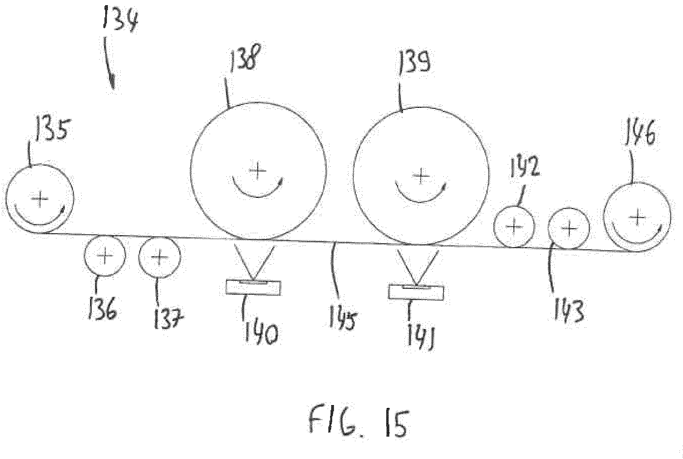

Figure 15 shows a coater generally referenced 134 with an unwind reel 135, two pre-drum rollers 136 and 137, a series of drums 138 and 139 each operating in conjunction with a source 140 and 141, two post-deposition rollers 142 and 143 entering into contact with the non-coated surface of the web 145, and a rewind reel 146. In a practical embodiment of figure 15, the unwind region with unwind reel 135 may be located on the same side of the coater as the rewind region 146. The arrangement of rollers may be employed to support and guide the web to and from the pair of evaporator drums. Furthermore, the evaporator region or regions may be segregated from the unwind and rewind regions with appropriate partitions or walls. Whilst the embodiment shows pairs of rollers a greater number of rollers is envisaged with the same properties in order to extend the achievable paths and further increase the advantages already achieved with pairs of rollers of this kind.

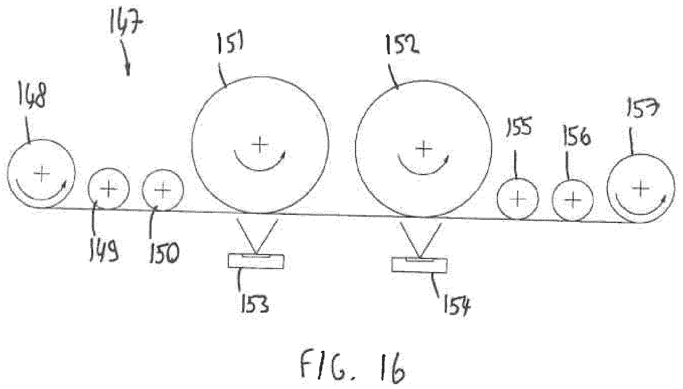

Figure 16 shows a coater 147 with an unwind reel 148, two pre-drum rollers 149 and 150, a series of two drums 151 and 152 operating with their respective evaporators 153 and 154, two post-deposition rollers 155 and 156, and a rewind reel 157. In a practical embodiment of figure 16, the unwind region with unwind reel 148 may be located on the same side of the coater as the rewind region 157. The arrangement of rollers may be employed to support and guide the web to and from the pair of evaporator drums. Furthermore, the evaporator region or regions may be segregated from the unwind and rewind regions with appropriate partitions or walls. Whilst the embodiment shows pairs of rollers a greater number of rollers is envisaged with the same properties in order to extend the achievable paths and further increase the advantages already achieved with pairs of rollers of this kind.

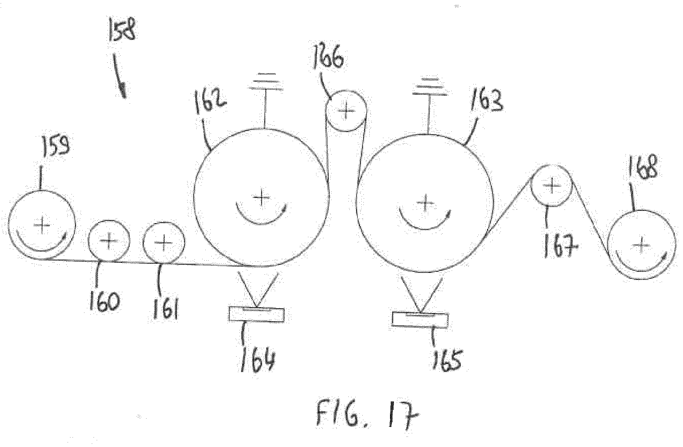

Figure 17 shows a coater 158 with an unwind reel 159, two pre-drum rollers 160 and 161, a series of drums 162 and 163 operating respectively in conjunction with evaporators 164 and 165, an intermediary electrically floating insulated roller 166, an electrically floating and insulated post-deposition roller 167 and a rewind reel 168. Each drum 162 and 163 may be grounded. In a practical embodiment of figure 17, the unwind region with unwind reel 159 may be located on the same side of the coater as the rewind region 168. The arrangement of rollers may be employed to support and guide the web to and from the pair of evaporator drums. Furthermore, the evaporator region or regions may be segregated from the unwind and rewind regions with appropriate partitions or walls. Whilst the embodiment shows one or more rollers, a greater number of rollers is envisaged with the same properties in order to extend the achievable paths and further increase the advantages already achieved with rollers of this kind.

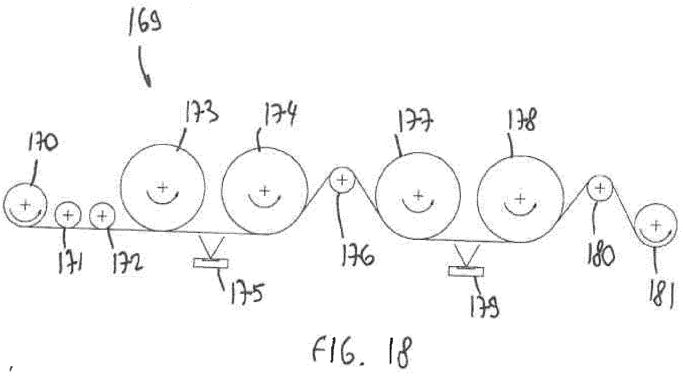

Figure 18 shows a coater 169 with an unwind reel 170, two pre-drum rollers 171 and 172, a first pair of drums 173 and 174 operating in conjunction with an evaporator 175, an intermediate roller 176 which is electrically floating or insulated, a second pair of drums 177 and 178 operating in conjunction with an evaporator 179, a post-deposition electrically floating or insulated roller 180 and a rewind reel 181. In a practical embodiment of figure 18, the unwind region with unwind reel 170 may be located on the same side of the coater as the rewind region 181. The arrangement of rollers may be employed to support and guide the web to and from the pair of evaporator drums. Furthermore, the evaporator region or regions may be segregated from the unwind and rewind regions with appropriate partitions or walls. Whilst the embodiment shows one or more rollers, a greater number of rollers is envisaged with the same properties in order to extend the achievable paths and further increase the advantages already achieved with rollers of this kind.

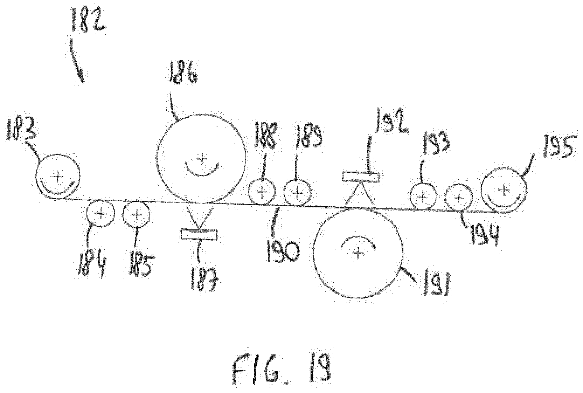

Figure 19 shows an unwind reel 183, a pair of pre-drum rollers 184 and 185, a first drum 186 operating in conjunction with an evaporator 187 to coat a first side of the web, two rollers 188 and 189 which enter into contact solely with the non-metallic surface of the web 190, a second drum 191 (which may electrically float, insulated or not grounded) operating in conjunction with a further evaporator 192 configured to coat the opposite side of the web, two post-deposition rollers 193 and 194, and a rewind reel 195. In a practical embodiment of figure 19, the unwind region with unwind reel 183 may be located on the same side of the coater as the rewind region 195. The arrangement of rollers may be employed to support and guide the web to and from the pair of evaporator drums. Furthermore, the evaporator region or regions may be segregated from the unwind and rewind regions with appropriate partitions or walls. Whilst the embodiment shows one or more rollers, a greater number of rollers is envisaged with the same properties in order to extend the achievable paths and further increase the advantages already achieved with rollers of this kind.

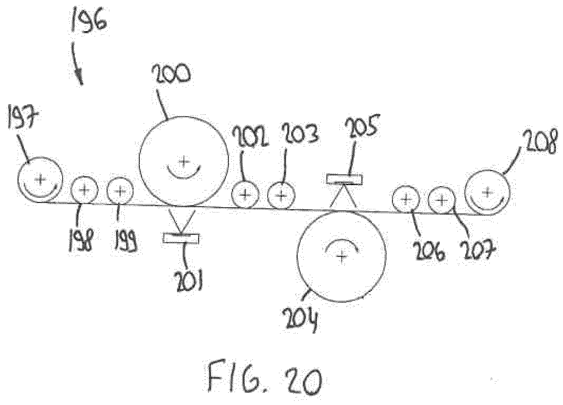

Figure 20 shows a coater 196 with an unwind reel 197, two rollers 198 and 199, a first drum 200 operating in conjunction with an evaporator 201, two intermediate rollers 202 and 203, a second drum 204 (which may electrically float, insulated or not grounded) operating in conjunction with an evaporator 205, two post-deposition drums 206 and 207, and a rewind reel 208. In a practical embodiment of figure 20, the unwind region with unwind reel 197 may be located on the same side of the coater as the rewind region 208. The arrangement of rollers may be employed to support and guide the web to and from the pair of evaporator drums. Furthermore, the evaporator region or regions may be segregated from the unwind and rewind regions with appropriate partitions or walls. Whilst the embodiment shows one or more rollers, a greater number of rollers is envisaged with the same properties in order to extend the achievable paths and further increase the advantages already achieved with rollers of this kind.

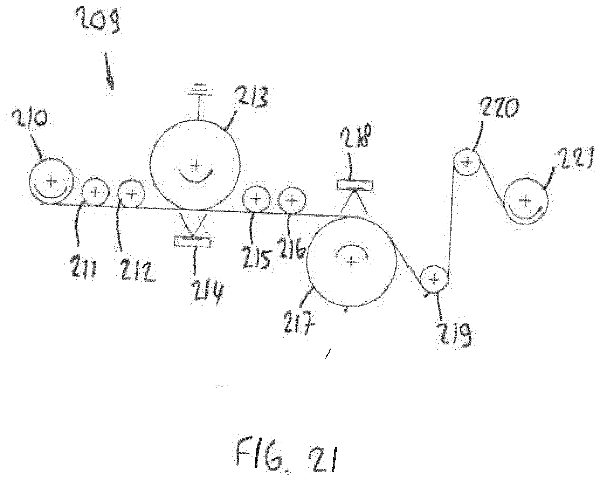

Figure 21 shows a coater 209 with an unwind reel 210, two pre-drum rollers 211 and 212, a first drum 213 operating in conjunction with an evaporator 214, two intermediate rollers 215 and 216, a second drum 217 operating in conjunction with a second evaporator 218, a post-deposition roller 219, a second post-deposition roller 220 and a rewind reel 221. This configuration allows the web to be coated on both sides. Drum 217, rollers 219 and 220 are electrically floating or insulated. In a practical embodiment of figure 21, the unwind region with unwind reel 210 may be located on the same side of the coater as the rewind region 221. The arrangement of rollers may be employed to support and guide the web to and from the pair of evaporator drums. Furthermore, the evaporator region or regions may be segregated from the unwind and rewind regions with appropriate partitions or walls. Whilst the embodiment shows one or more rollers, a greater number of rollers is envisaged with the same properties in order to extend the achievable paths and further increase the advantages already achieved with rollers of this kind.

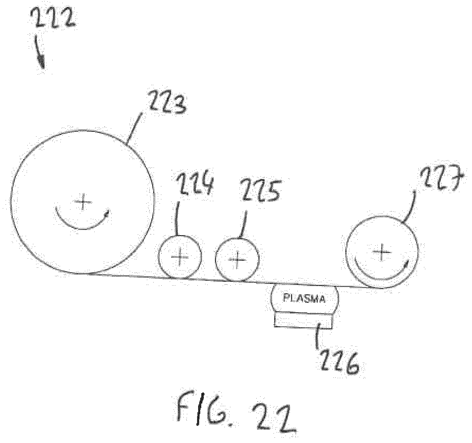

Figure 22 shows a coater 222 with a drum 223, two post-deposition rollers 224 and 225, a plasma passivation/static neutralisation device 226 prior to rewind roll 227. The plasma passivation/static neutralisation device may either act on one side of the web or on both sides as required.

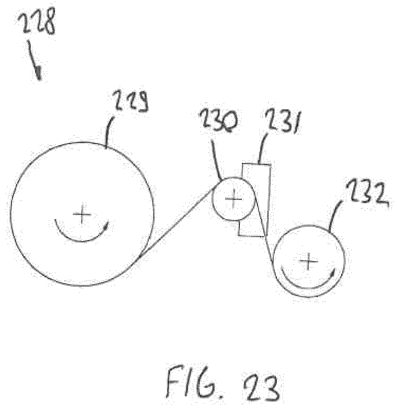

Figure 23 shows a coater 228 with a drum 229 and a floating contact roller 230 closely associated with a plasma passivation/static neutralisation device 231 and a rewind reel 232. This configuration may be one or two sided.

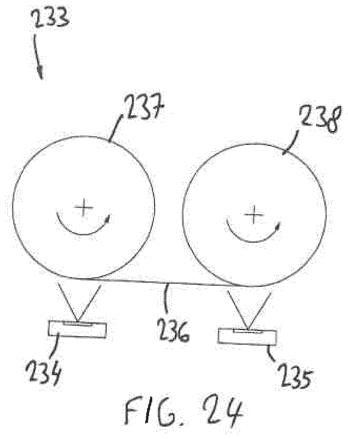

Figure 24 shows a coater 233 comprising two sources 234 and 235 selected to reduce electromagnetic radiation into the conductive coated film 236. Two drums 237 and 238 are provided.

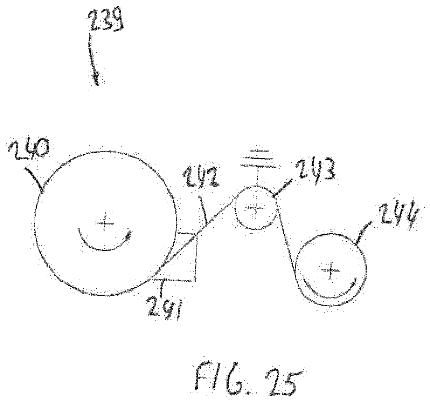

Figure 25 shows a coater 239 with a drum 240, a plasma passivation/static neutralisation device 241 located in the separation region as the web 242 separates from drum 240, a post-deposition roller 243 which is grounded and a rewind reel 244.

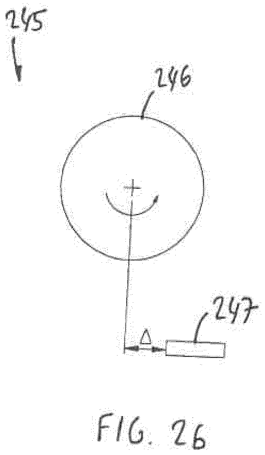

Figure 26 shows a coater 245 with a drum 246 and an evaporator 247 which is offset relative to the central axis of the drum in order to reduce electromagnetic induced currents in the metallised web.

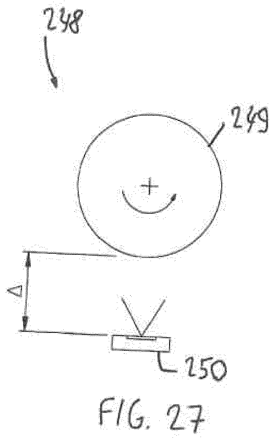

Figure 27 shows a coater 248 with a drum 249 and an evaporator 250. The drum is separated from the evaporator by an increased distance. In particular, the height between the evaporator and the drum is substantially greater than conventional coaters.

The following further embodiments are provided to illustrate the invention in the context of electrostatic discharge:
a) reducing electrostatic generation in the metallised web via the speed of operation;
b) reducing electrostatic generation via speed matching by for example employing Capstan draw rollers;
c) reducing electrostatic generation by appropriately spreading the web;
d) reducing electrostatic generation by providing earthed rollers prior to coating;
e) reducing electrostatic generation by reducing electromagnetic induced static by lowering the power of the operation;
f) reducing electrostatic generation by employing an appropriate pressure regime;
g) preventing discharge by providing non-contact web paths post-deposition;
h) preventing discharge by electrically floating rollers particularly post-deposition;
i) preventing discharge by using non-electrically conducting rollers/thermally conducting rollers;
j) controlling discharge by employing static discharge bars in vacuum post-deposition (with forced gas);
k) controlling discharge by electrostatic discharge via non-contact plasma passivation/static discharge - plasma post-treatments.
l) pre-plasma treatment to neutralise static from unwind reel;
m) reducing or preventing discharge by post-plasma treatment to neutralise the electrostatic in the web;
n) controlling discharge by post-gas injection of an ionised gas to passivate the layer;
o) reducing electrostatic generation by appropriately controlling the electromagnetic induced charging and discharging of evaporator boats.
p) plasma discharging onto rollers due to charge levels exceeding breakdown voltage of residual gas and plasma generation between micro-topography of roller and film surface - possible reduction if running machines in 10⁻⁴mbar region;
q) Controlling discharge by providing appropriate roller surfaces such as nitrile;
r) management of unwind zone pressure regime. In one embodiment a three zone machine may be beneficial where higher residual water vapour may be in the unwind zone to passivate reel as it unwinds whereby no polycolds are in the first zone. The third zone pumps to 10⁻²mbar with water vapour traps located in this zone separated from zone 1 to remove moisture from film prior to entering evaporation zone.

The following further embodiments are envisaged in the context of electric discharge:
a) reducing electric discharge from the metallised web via the speed of operation;
b) reducing electric discharge via speed matching by for example employing Capstan draw rollers;
c) reducing electric discharge by appropriately spreading the web;
d) reducing electric discharge by providing earthed rollers after the coating;
e) reducing electric discharge by reducing electromagnetic induced current by lowering the power of the operation of one or more evaporators;
f) reducing electric discharge by employing an appropriate pressure regime;
g) preventing electric discharge by providing non-contact web paths post-deposition;
h) preventing discharge by electrically floating rollers particularly post-deposition;
i) preventing discharge by using non-electrically conducting rollers/thermally conducting rollers;
j) controlling discharge by employing static discharge bars in vacuum post-deposition (with forced gas);
k) controlling discharge by electrostatic discharge via non-contact plasma passivation/static discharge - plasma post-treatments.
l) pre-plasma treatment to reduce electric discharge from unwind reel;
m) reducing or preventing discharge by post-plasma treatment to neutralise the web;
n) controlling discharge by post-gas injection of an ionised gas to passivate the layer;
o) reducing electric discharge by appropriately controlling the electromagnetic induced charging and discharging of evaporator boats.
p) plasma discharging onto rollers due to charge levels exceeding breakdown voltage of residual gas and plasma generation between micro-topography of roller and film surface - possible reduction if running machines in 10⁻⁴mbar region;
q) Controlling discharge by providing appropriate roller surfaces such as nitrile;
r) management of unwind zone pressure regime. In one embodiment a three zone machine may be beneficial where higher residual water vapour may be in the unwind zone to passivate reel as it unwinds whereby no polycolds are in the first zone. The third zone pumps to 10⁻²mbar with water vapour traps located in this zone separated from zone 1 to remove moisture from film prior to entering evaporation zone.

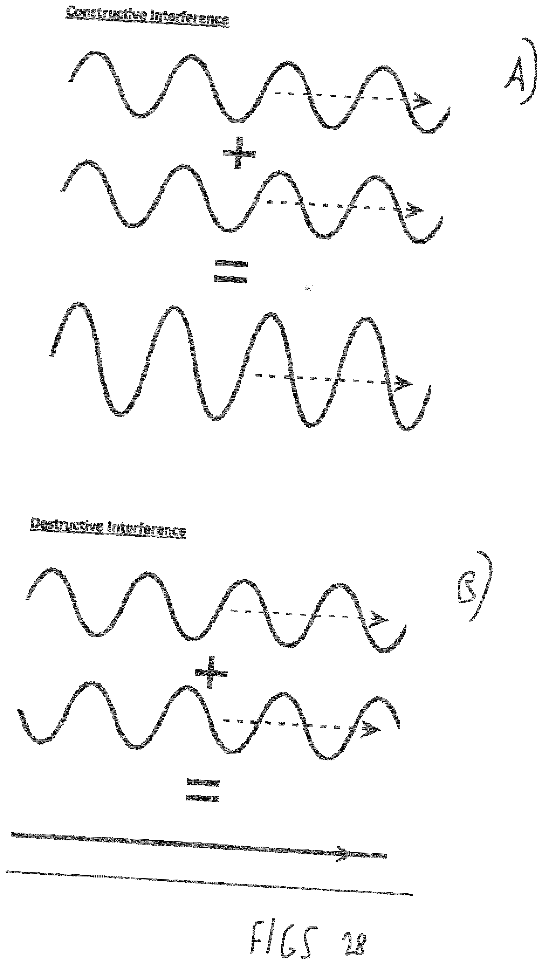

Figures 28A and 28B illustrate that in certain instances electromagnetic waves can interact to provide constructive interference where the amplitude and size of the resulting wave is much larger or they can interact to result in destructive interference where the amplitude and size of the resulting wave is greatly reduced. In embodiments where several evaporator boats are located adjacent to each other there may be either constructive or destructive interference between the electromagnetic fields generated. In the case of running higher current levels to allow faster coating speeds larger electromagnetic fields extend from the ceramic evaporator boat. This large electric magnetic field can result in induced charging of the conductive layer on the polymeric film that passes through the evaporation zone on the process drum and this induced charge can also result in electric discharge between the vacuum coated polymeric layer and any roller in contact with it creating micro-defects and pinholes in the vacuum coated layer. By providing means to control this electromagnetic effect a reduction of micro-defects and pinholes may be achieved.

## Claims

1. A vacuum coater (1) for coating a polymeric web (5) with metal or metal oxide comprising an unwind region (2), which when the coater is in use, carries an unwind reel of polymeric web (5), said unwind region (2) incorporating a plurality of pre-drum rollers (301, 302, 303, 304); a deposition region (3) comprising an evaporator (13) and a drum (6); said polymeric web (5) extending, when the coater is in use, about at least part of the circumference of said drum whilst evaporated metal or metal oxide is deposited onto the polymeric web's surface; and a rewind region (4), which when the coater is in use, carries a rewound reel of coated polymeric web; said coated polymeric web having, post-deposition, on one side an uncoated surface (5N) and on the other side a coated surface (5M) of metal or metal oxide; **characterised in that** said unwind and rewind regions are segregated by a wall (305) from said deposition region; and a plurality of post-drum rollers (7, 8, 9, 10, 10A) which are located outside of the segregated deposition region and which are provided to support the coated web between said drum and said rewind reel; said unwind reel and said rewind reel being provided adjacent to one another on a first side of said drum whilst said plurality of post-drum rollers comprise a distal post-drum roller (7) which is located outside of the segregated deposition region and further away from the rewind reel than the drum at the opposite side of said drum and a plurality of further post-drum rollers define a path to return the coated web to said first side of the drum; each one of said post-drum rollers being solely in contact with the uncoated polymeric surface (5N) of the metallised or metal oxide coated web.

2. A vacuum coater according to claim 1, wherein said plurality of pre-drum rollers are configured to solely support said web prior to the deposition on the opposite side of the web to the side where metal or metal oxide is to be deposited.

3. A vacuum coater according to either claim 1 or claim 2, wherein at least one of said pre and post-drum rollers incorporates a polymeric coating on the surface of the roller.

4. A vacuum coater according to any of the preceding claims, further comprising means for preventing or minimising the discharge of electrostatic charge after deposition; wherein said means are selected from the group comprising:
• at least one of said post-drum rollers being electrically isolated;
• at least one of said post-drum rollers being non-electrically conductive;
• at least one of said post-drum rollers being supported by non-conductive bearings;
• at least one electrically floating roller after the deposition.

5. A vacuum coater according to any of the preceding claims, wherein at least one of said pre-drum rollers is earthed to substantially remove or at least reduce electrostatic charge from said web.

6. A vacuum coater according to any of the preceding claims, further comprising a controllable discharge means selected from one or more of the following:
• a static discharge bar;
• means for generating an ionised gas and for exposing said web to ionised gas after deposition;
• means for injecting an ionised gas in the vicinity of a web to passivate said web;
• a plasma treater prior to deposition;
• a plasma treater after deposition; preferably prior to contact with the first post-drum roller;
• a plasma treater for applying a plasma treatment in the region where the web separates from the evaporator's drum;
• a static discharge means;
• means for controlling the speed of either the web or the rollers;
• means for varying the pressure regime;
• rollers with a configuration which tends to spread the web as the web is drawn over the rollers;
• rollers at least partially of cork, nitrile rubber and steel;
• means for controlling the electromagnetic field generated by said evaporator;

7. A vacuum coater according to any of the preceding claims, wherein said coater further comprises at least one roller with an insulating coating on the surface of the roller, preferably said insulating coating is selected from the group comprising: Cubic Boron Nitride, Aluminium Nitride, and Beryllium oxide.

8. A vacuum coater according to any of the preceding claims, wherein said at least one roller incorporates a ceramic coating on the surface of the roller.

9. A vacuum coater according to any of the preceding claims, wherein a plurality of rollers are provided post-deposition which define a path located on the outmost portion of the succession of rollers.

10. A method of operating a vacuum coater according to any of the preceding claims comprising the steps of solely supporting said web after the deposition on the polymeric surface of the metallised or metal oxide coated web; and providing said unwind reel and said rewind reel adjacent to one another on a first side of said drum whilst said plurality of post-drum rollers comprise a distal post-drum roller which is located outside of the segregated deposition region and is located further away from the rewind reel than the drum at the opposite side of said drum and a plurality of further post-drum rollers which are located outside of the segregated deposition region and which define a path to return the coated web to said first side of the drum.

11. A method according to claim 10, comprising the step of providing a polymeric coating on the surface of one or more roller.

12. A method according to either claim 10 or claim 11, comprising the step of solely supporting said web prior to the deposition on the opposite side of the web to the side where metal or metal oxide is to be deposited.

13. A method according to any one of claims 10 to 12, comprising the steps of controlling the discharge of electrostatic charge from the web after the deposition of metal or metal oxide onto the web.

14. A method according to any one of claims 10 to 12 comprising the steps of preventing the discharge of electrostatic charge from the web after the deposition of metal or metal oxide onto the web.

## Patentansprüche

1. Vakuumbeschichtungsvorrichtung (1) zum Beschichten eines Polymergewebes (5) mit Metall oder Metalloxid, umfassend einen Abwicklungsbereich (2), der bei der Verwendung der Beschichtungsvorrichtung eine Abwicklungsspule eines Polymergewebes (5) trägt, wobei der Abwicklungsbereich (2) eine Mehrzahl von Walzen (301, 302, 303, 304) vor einer Trommel aufweist; einen Auftragungsbereich (3), der einen Verdampfer (13) und eine Trommel (6) umfasst; wobei sich das Polymergewebe (5) bei der Verwendung der Beschichtungsvorrichtung um zumindest einen Teil des Umfangs der Trommel herum erstreckt, während verdampftes Metall oder Metalloxid auf die Oberfläche des Polymergewebes aufgetragen wird; und einen Aufwicklungsbereich (4), der bei der Verwendung der Beschichtungsvorrichtung eine aufgewickelte Spule eines beschichteten Polymergewebes trägt; wobei das beschichtete Polymergewebe nach der Auftragung auf einer Seite eine unbeschichtete Oberfläche (5N) und auf der anderen Seite eine beschichtete Oberfläche (5M) aus Metall oder Metalloxid hat; **dadurch gekennzeichnet, dass** der Abwicklungs- und der Aufwicklungsbereich durch eine Wand (305) vom Auftragungsbereich abgetrennt sind; und eine Mehrzahl von Walzen (7, 8, 9, 10, 10A) nach der Trommel, die außerhalb des abgetrennten Auftragungsbereichs angeordnet ist und dafür vorgesehen ist, das beschichtete Gewebe zwischen der Trommel und der Aufwicklungsspule zu tragen; wobei die Abwicklungsspule und die Aufwicklungsspule auf einer ersten Seite der Trommel benachbart zueinander vorgesehen sind, während die Mehrzahl von Walzen nach der Trommel auf der entgegengesetzten Seite der Trommel eine distale Walze (7) nach der Trommel umfasst, die außerhalb des abgetrennten Auftragungsbereichs angeordnet ist und von der Aufwicklungsspule weiter als die Trommel entfernt ist, und eine Mehrzahl von weiteren Walzen nach der Trommel einen Weg zum Rückführen des beschichteten Gewebes zur ersten Seite der Trommel definiert; wobei jede der Walzen nach der Trommel nur mit der unbeschichteten Polymeroberfläche (5N) des metallisierten oder mit Metalloxid beschichteten Gewebes in Kontakt steht.

2. Vakuumbeschichtungsvorrichtung nach Anspruch 1, wobei die Mehrzahl von Walzen vor der Trommel dafür ausgebildet ist, das Gewebe vor der Auftragung nur auf der entgegengesetzten Seite des Gewebes zu der Seite, auf die Metall oder Metalloxid aufgetragen werden soll, zu tragen.

3. Vakuumbeschichtungsvorrichtung nach Anspruch 1 oder Anspruch 2, wobei zumindest eine der Walzen vor und nach der Trommel eine Polymerbeschichtung auf der Oberfläche der Walze aufweist.

4. Vakuumbeschichtungsvorrichtung nach einem der vorstehenden Ansprüche, weiter umfassend Mittel zum Verhindern oder Minimieren der Entladung einer elektrostatischen Ladung nach der Auftragung; wobei die Mittel aus der Gruppe ausgewählt sind, die umfasst:
• dass zumindest eine der Walzen nach der Trommel galvanisch getrennt ist;
• dass zumindest eine der Walzen nach der Trommel nicht elektrisch leitfähig ist;
• dass zumindest eine der Walzen nach der Trommel von nicht leitfähigen Lagern getragen wird;
• zumindest eine elektrisch potenzialfreie Walze nach der Auftragung.

5. Vakuumbeschichtungsvorrichtung nach einem der vorstehenden Ansprüche, wobei zumindest eine der Walzen vor der Trommel geerdet ist, um eine elektrostatische Ladung aus dem Gewebe im Wesentlichen zu entfernen oder zumindest zu verringern.

6. Vakuumbeschichtungsvorrichtung nach einem der vorstehenden Ansprüche, weiter umfassend ein steuerbares Entladungsmittel, das aus einem oder mehreren der folgenden ausgewählt ist:
• einer statischen Entladungselektrode;
• Mitteln zum Erzeugen eines ionisierten Gases und zum Aussetzen des Gewebes an das ionisierte Gas nach der Auftragung;
• Mitteln zum Injizieren eines ionisierten Gases in der Umgebung eines Gewebes zum Passivieren des Gewebes;
• einer Plasmabehandlungsvorrichtung vor der Auftragung;
• einer Plasmabehandlungsvorrichtung nach der Auftragung; vorzugsweise vor dem Kontakt mit der ersten Walze nach der Trommel;
• einer Plasmabehandlungsvorrichtung zum Anwenden einer Plasmabehandlung in dem Bereich, in dem sich das Gewebe von der Trommel des Verdampfers löst;
• einem statischen Entladungsmittel;
• Mitteln zum Steuern der Geschwindigkeit des Gewebes oder der Walzen;
• Mitteln zum Variieren des vorgegebenen Drucks;
• Walzen mit einer Konfiguration, die zum Ausbreiten des Gewebes neigt, wenn das Gewebe über die Walzen gezogen wird;
• Walzen, die zumindest teilweise aus Kork, Nitrilkautschuk und Stahl bestehen;
• Mitteln zum Regulieren des elektromagnetischen Felds, das vom Verdampfer erzeugt wird.

7. Vakuumbeschichtungsvorrichtung nach einem der vorstehenden Ansprüche, wobei die Beschichtungsvorrichtung weiter zumindest eine Walze mit einer Isolierbeschichtung auf der Oberfläche der Walze umfasst, wobei die Isolierbeschichtung vorzugsweise aus der Gruppe ausgewählt ist, die umfasst: kubisches Bornitrid, Aluminiumnitrid und Berylliumoxid.

8. Vakuumbeschichtungsvorrichtung nach einem der vorstehenden Ansprüche, wobei die zumindest eine Walze eine Keramikbeschichtung auf der Oberfläche der Walze aufweist.

9. Vakuumbeschichtungsvorrichtung nach einem der vorstehenden Ansprüche, wobei eine Mehrzahl von Walzen nach der Auftragung vorgesehen ist, die einen Weg definiert, der sich am äußersten Teil der Reihe von Walzen befindet.

10. Verfahren zum Betreiben einer Vakuumbeschichtungsvorrichtung nach einem der vorstehenden Ansprüche, umfassend die Schritte des Tragens des Gewebes nach der Auftragung nur auf der Polymeroberfläche des metallisierten oder mit Metalloxid beschichteten Gewebes; und Vorsehen der Abwicklungsspule und der Aufwicklungsspule auf einer ersten Seite der Trommel benachbart zueinander, während die Mehrzahl von Walzen nach der Trommel auf der entgegengesetzten Seite der Trommel eine distale Walze nach der Trommel umfasst, die außerhalb des abgetrennten Auftragungsbereichs angeordnet ist und von der Aufwicklungsspule weiter als die Trommel entfernt ist, und eine Mehrzahl von weiteren Walzen nach der Trommel, die außerhalb des abgetrennten Auftragungsbereichs angeordnet ist und einen Weg zum Rückführen des beschichteten Gewebes zur ersten Seite der Trommel definiert.

11. Verfahren nach Anspruch 10, umfassend den Schritt des Vorsehens einer Polymerbeschichtung auf der Oberfläche einer oder mehrerer Walzen.

12. Verfahren nach Anspruch 10 oder Anspruch 11, umfassend den Schritt des Tragens des Gewebes vor der Auftragung nur auf der entgegengesetzten Seite des Gewebes zu der Seite, auf die Metall oder Metalloxid aufgetragen werden soll.

13. Verfahren nach einem der Ansprüche 10 bis 12, umfassend die Schritte des Steuerns der Entladung einer elektrostatischen Ladung aus dem Gewebe nach der Auftragung von Metall oder Metalloxid auf das Gewebe.

14. Verfahren nach einem der Ansprüche 10 bis 12, umfassend die Schritte des Verhinderns der Entladung einer elektrostatischen Ladung aus dem Gewebe nach der Auftragung von Metall oder Metalloxid auf das Gewebe.

## Revendications

1. Machine à enduire sous vide (1) pour revêtir une bande polymère (5) avec un métal ou un oxyde de métal comprenant une région de déroulement (2), qui lorsque la machine à enduire est en fonctionnement, porte une bobine de déroulement de bande polymère (5), ladite région de déroulement (2) incorporant une pluralité de rouleaux à pré-cylindre (301, 302, 303, 304); une région de dépôt (3) comprenant un évaporateur (13) et un cylindre (6) ; ladite bande polymère (5) s'étendant, lorsque la machine à enduire est en fonctionnement, autour d'au moins une partie de la circonférence dudit cylindre tandis que du métal ou de l'oxyde de métal évaporé est déposé sur la surface de la bande polymère ; et une région d'enroulement (4), qui lorsque la machine à enduire est en fonctionnement, porte une bobine enroulée de bande polymère revêtue ; ladite bande polymère revêtue ayant, après dépôt, sur un côté une surface non revêtue (5N) et sur l'autre côté une surface revêtue (5M) de métal ou d'oxyde de métal ; **caractérisée en ce que** lesdites régions de déroulement et d'enroulement sont isolées par une paroi (305) de ladite région de dépôt; et une pluralité de rouleaux à post-cylindre (7, 8, 9, 10, 10A) qui sont situés à l'extérieur de la région de dépôt isolée et qui sont prévus pour supporter la bande revêtue entre ledit cylindre et ladite bobine d'enroulement ; ladite bobine de déroulement et ladite bobine d'enroulement étant disposées adjacentes l'une à l'autre sur un premier côté dudit cylindre tandis que ladite pluralité de rouleaux à post-cylindre comprend un rouleau à post-cylindre distal (7) qui est situé à l'extérieur de la région de dépôt isolée et plus loin de la bobine d'enroulement que le cylindre au niveau du côté opposé dudit cylindre et une pluralité de rouleaux à post-cylindre supplémentaires définissent un chemin pour renvoyer la bande revêtue vers ledit premier côté du cylindre ; chacun desdits rouleaux à post-cylindre étant seulement en contact avec la surface polymère non revêtue (5N) de la bande métallisée ou revêtue d'oxyde de métal.

2. Machine à enduire sous vide selon la revendication 1, dans laquelle ladite pluralité de rouleaux à pré-cylindre est configurée pour seulement supporter ladite bande avant le dépôt sur le côté opposé de la bande sur le côté où le métal ou l'oxyde de métal doit être déposé.

3. Machine à enduire sous vide selon la revendication 1 ou la revendication 2, dans laquelle au moins un desdits rouleaux à pré- et post-cylindre incorpore un revêtement polymère sur la surface du rouleau.

4. Machine à enduire sous vide selon l'une quelconque des revendications précédentes, comprenant en outre un moyen pour empêcher ou réduire au minimum la décharge de charges électrostatiques après dépôt; dans laquelle ledit moyen est sélectionné à partir du groupe comprenant :
• au moins un desdits rouleaux à post-cylindre étant électriquement isolé ;
• au moins un desdits rouleaux à post-cylindre étant non électriquement conducteur ;
• au moins un desdits rouleaux à post-cylindre étant supporté par des paliers non conducteurs ;
• au moins un rouleau électriquement flottant après le dépôt.

5. Machine à enduire sous vide selon l'une quelconque des revendications précédentes, dans laquelle au moins un desdits rouleaux à pré-cylindre est mis à la masse pour sensiblement enlever ou au moins réduire les charges électrostatiques depuis ladite bande.

6. Machine à enduire sous vide selon l'une quelconque des revendications précédentes, comprenant en outre un moyen de décharge pouvant être commandé sélectionné à partir d'une ou plusieurs choses de ce qui suit :
• une barre de décharge statique ;
• un moyen pour produire un gaz ionisé et pour exposer ladite bande au gaz ionisé après dépôt ;
• un moyen pour injecter un gaz ionisé au voisinage d'une bande pour passiver ladite bande ;
• un dispositif de traitement au plasma avant dépôt ;
• un dispositif de traitement au plasma après dépôt; de préférence avant contact avec le premier rouleau à post-cylindre ;
• un dispositif de traitement au plasma pour appliquer un traitement au plasma dans la région où la bande se sépare du cylindre de l'évaporateur ;
• un moyen de décharge statique ;
• un moyen pour commander la vitesse de l'un ou l'autre de la bande ou des rouleaux ;
• un moyen pour varier le régime de pression ;
• des rouleaux avec une configuration qui a tendance à étendre la bande lorsque la bande est tirée sur les rouleaux ;
• des rouleaux au moins partiellement en liège, caoutchouc nitrile et acier ;
• un moyen pour commander le champ électromagnétique produit par ledit évaporateur.

7. Machine à enduire sous vide selon l'une quelconque des revendications précédentes, dans laquelle ladite machine à enduire comprend en outre au moins un rouleau avec un revêtement isolant sur la surface du rouleau, de préférence ledit revêtement isolant est sélectionné à partir du groupe comprenant : Nitrure de Bore Cubique, Nitrure d'Aluminium et oxyde de Béryllium.

8. Machine à enduire sous vide selon l'une quelconque des revendications précédentes, dans laquelle ledit au moins un rouleau incorpore un revêtement céramique sur la surface du rouleau.

9. Machine à enduire sous vide selon l'une quelconque des revendications précédentes, dans laquelle une pluralité de rouleaux sont prévus après dépôt qui définissent un chemin situé sur la portion la plus éloignée de la succession de rouleaux.

10. Procédé de mise en oeuvre d'une machine à enduire sous vide selon l'une quelconque des revendications précédentes comprenant les étapes consistant à seulement supporter ladite bande après le dépôt sur la surface polymère de la bande métallisée ou revêtue d'oxyde de métal ; et la disposition de ladite bobine de déroulement et de ladite bobine d'enroulement adjacentes l'une à l'autre sur un premier côté dudit cylindre tandis que ladite pluralité de rouleaux à post-cylindre comprend un rouleau à post-cylindre distal qui est situé à l'extérieur de la région de dépôt isolée et qui est situé plus loin de la bobine d'enroulement que le cylindre au niveau du côté opposé dudit cylindre et une pluralité des rouleaux à post-cylindre supplémentaires qui sont situés à l'extérieur de la région de dépôt isolée et qui définissent un chemin pour renvoyer la bande revêtue vers ledit premier côté du cylindre.

11. Procédé selon la revendication 10, comprenant l'étape consistant à fournir un revêtement polymère sur la surface d'un ou plusieurs rouleaux.

12. Procédé selon la revendication 10 ou la revendication 11, comprenant l'étape consistant à seulement supporter ladite bande avant le dépôt sur le côté opposé de la bande sur le côté où le métal ou l'oxyde de métal doit être déposé.

13. Procédé selon l'une quelconque des revendications 10 à 12, comprenant les étapes consistant à commander la décharge de charges électrostatiques depuis la bande après le dépôt de métal ou d'oxyde de métal sur la bande.

14. Procédé selon l'une quelconque des revendications 10 à 12, comprenant les étapes consistant à empêcher la décharge de charges électrostatiques depuis la bande après le dépôt de métal ou d'oxyde de métal sur la bande.
